# EUROPEAN PATENT APPLICATION

(11) **EP 4 701 083 A1**
(43) Date of publication of application: **25.02.2026**
(21) Application number: 25186673.7
(22) Date of filing: 01.07.2025
(51) Int. Cl.: H03L 7/085, H03L 7/10, H03L 7/197

(54) **DIGITAL PHASE ALIGNMENT FOR PHASE-LOCKED LOOP (PLL) CIRCUITRY**

(30) Priority: 19.08.2024 US 202418808949
(71) Applicant: Apple Inc., Cupertino, CA 95014 (US)
(72) Inventor: SZCZYPINSKI, Kazimierz Eugeniusz, Munich (DE); PREYLER, Peter L, Weyer (AT); DIETL-STEINMAURER, Herwig, Wels (AT); WICPALEK, Christian, Puchenau (AT); MAYER, Thomas, Linz (AT)
(74) Representative: COPA Copenhagen Patents

(57) **Abstract**

Wireless circuitry may include phase-locked loop (PLL) circuitry. The PLL circuitry can include a time-to-digital converter (TDC) having a first input configured to receive a reference clock signal, a second input configured to receive a feedback clock signal, and an output at which a measured phase error is produced, a frequency divider configured to output the feedback clock signal, and a phase alignment circuit configured to output a corrected phase error that is used in adjusting the frequency divider. The phase alignment circuit can include a scaling component configured to scale the measured phase error by a phase alignment coefficient to produce a corresponding scaled phase error and a multiplexing component configured to selectively output a corrected phase error that is used in controlling a sigma delta modulator coupled to the divider.

## Description

This application claims priority to U.S. patent application No. 18/808,949, filed August 19, 2024, which is hereby incorporated by reference herein in its entirety.

### Field

This disclosure relates generally to electronic devices, including electronic devices with wireless communications circuitry.

### Background

Electronic devices are often provided with wireless communications capabilities. An electronic device with wireless communications capabilities has wireless communications circuitry with one or more antennas. Transceiver circuitry in the wireless communications circuitry uses the antennas to receive and transmit radio-frequency signals.

The transceiver circuitry can include one or more mixers for modulating or demodulating the radio-frequency signals. The mixers can receive a local oscillator signal from a phase-locked loop. It can be challenging to design a satisfactory phase-locked loop for the wireless communications circuitry.

### Summary

An aspect of the disclosure provides phase-locked loop (PLL) circuitry that includes: a time-to-digital converter having a first input configured to receive a reference clock signal, a second input configured to receive a feedback clock signal, and an output at which a measured phase error is produced; a frequency divider configured to output the feedback clock signal; and a phase alignment circuit configured to output a corrected phase error that is used in adjusting the frequency divider. The PLL circuitry can further include a digitally controlled oscillator configured to produce an output clock signal that is conveyed to the frequency divider, a digital loop filter having an output coupled to the digitally controlled oscillator, and a sigma delta modulator configured to output a control signal to the frequency divider. The phase alignment circuit can include a scaling component configured to scale the measured phase error by a phase alignment coefficient to produce a corresponding scaled phase error and can further include a multiplexing component configured to selectively output a corrected phase error that is used in controlling the sigma delta modulator.

An aspect of the disclosure provides a method of operating phase-locked loop circuitry that includes: selectively activating one or more components within the phase-locked loop circuitry while the phase-locked loop circuitry remains in an open-loop state, where the one or more components being activated include a time-to-digital converter and a frequency divider; with the frequency divider, outputting a feedback clock signal; with the time-to-digital converter, receiving a reference clock signal and the feedback clock signal and outputting a corresponding measured phase error; and with a phase alignment circuit, outputting a corrected phase error based on the measured phase error and adjusting the frequency divider based on the corrected phase error. The method can further include: with a sigma delta modulator, outputting a control signal to the frequency divider, where the control signal is generated based on the corrected phase error and a division ratio associated with the frequency divider; with a multiplexing component, receiving the corrected phase error, a null signal, and a trigger signal; and with the multiplexing component, outputting the null signal when the trigger signal has a first value and outputting the corrected phase error when the trigger signal has a second value different than the first value. The method can further include computing a scaled phase error based on the measured phase error and a static phase alignment coefficient and computing the corrected phase error by combining the scaled phase error and noise cancellation information output from the sigma delta modulator.

An aspect of the disclosure comprises circuitry that includes a plurality of circuit components selectively coupled together in a loop and having a phase error and a digital phase alignment circuit coupled to the plurality of circuit components and configured to reduce the phase error from a first value to a second value before a component in the plurality of circuit components is enabled to close the loop. The plurality of circuit components can include a time-to-digital converter, a loop filter, a frequency divider, and an oscillator. The digital phase alignment circuit can be configured to apply a correction value to a signal received at an input of a sigma delta modulator coupled to the frequency divider.

### Brief Description of the Drawings

FIG. 1 is a diagram of an illustrative electronic device having wireless circuitry in accordance with some embodiments.
FIG. 2 is a diagram of illustrative wireless circuitry having a transceiver in accordance with some embodiments.
FIG. 3 is a diagram of illustrative wireless circuitry having a mixer configured to receive a local oscillator signal from phase-locked loop (PLL) circuitry in accordance with some embodiments.
FIG. 4 is a schematic diagram of illustrative PLL circuitry that includes digital phase alignment circuitry in accordance with some embodiments.
FIG. 5 is a flowchart of illustrative steps for operating PLL circuitry of the type shown in FIG. 4 in accordance with some embodiments.
FIG. 6 is a timing diagram showing how the PLL circuitry of FIG. 4 can be operated to reduce phase error in accordance with some embodiments.

### Detailed Description

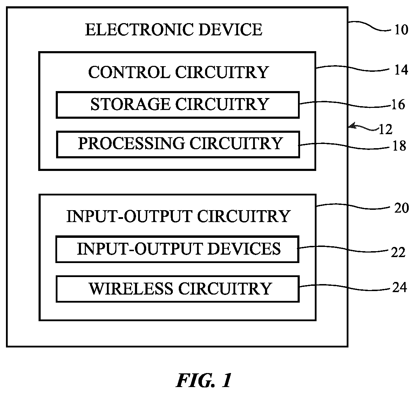

An electronic device such as electronic device 10 of FIG. 1 may be provided with wireless circuitry. The wireless circuitry may include phase-locked loop (PLL) circuitry configured to generate one or more local oscillator signals. The PLL circuitry may be implemented as digital PLL circuitry. The digital PLL circuitry can include a digital phase alignment circuit configured to provide digital phase (error) correction. The digital phase alignment circuit can include an error estimation component, a scaling component, and an error correction component.

The error estimation component can be configured to obtain an initial phase error using a measurement output from a time-to-digital converter (TDC) configured to compare a reference clock signal and a feedback clock signal. The scaling component can be configured to convert the estimated phase error into a digital oscillator clock domain. The error correction component can be configured to produce a corrected phase error based on the converted phase error. Digital PLL circuitry configured and operated in this way can be technically advantageous and beneficial to provide a significantly reduced locking time by generating a smaller starting feedback phase error while optimizing power savings (e.g., by allowing use of slower reference clock frequencies while still satisfying lock and re-lock timing requirements and while maximizing PLL off times).

Electronic device 10 of FIG. 1 that includes digital PLL circuitry may be a computing device such as a laptop computer, a desktop computer, a computer monitor containing an embedded computer, a tablet computer, a cellular telephone, a media player, or other handheld or portable electronic device, a smaller device such as a wristwatch device, a pendant device, a headphone or earpiece device, a device embedded in eyeglasses or other equipment worn on a user's head, or other wearable or miniature device, a television, a computer display that does not contain an embedded computer, a gaming device, a navigation device, an embedded system such as a system in which electronic equipment with a display is mounted in a kiosk or automobile, a wireless internet-connected voice-controlled speaker, a home entertainment device, a remote control device, a gaming controller, a peripheral user input device, a wireless base station or access point, equipment that implements the functionality of two or more of these devices, or other electronic equipment.

As shown in the functional block diagram of FIG. 1, device 10 may include components located on or within an electronic device housing such as housing 12. Housing 12, which may sometimes be referred to as a case, may be formed from plastic, glass, ceramics, fiber composites, metal (e.g., stainless steel, aluminum, metal alloys, etc.), other suitable materials, or a combination of these materials. In some embodiments, parts or all of housing 12 may be formed from dielectric or other low-conductivity material (e.g., glass, ceramic, plastic, sapphire, etc.). In other embodiments, housing 12 or at least some of the structures that make up housing 12 may be formed from metal elements.

Device 10 may include control circuitry 14. Control circuitry 14 may include storage such as storage circuitry 16. Storage circuitry 16 may include hard disk drive storage, nonvolatile memory (e.g., flash memory or other electrically-programmable-read-only memory configured to form a solid-state drive), volatile memory (e.g., static or dynamic random-access-memory), etc. Storage circuitry 16 may include storage that is integrated within device 10 and/or removable storage media.

Control circuitry 14 may include processing circuitry such as processing circuitry 18. Processing circuitry 18 may be used to control the operation of device 10. Processing circuitry 18 may include on one or more microprocessors, microcontrollers, digital signal processors, host processors, baseband processor integrated circuits, application specific integrated circuits, central processing units (CPUs), etc. Control circuitry 14 may be configured to perform operations in device 10 using hardware (e.g., dedicated hardware or circuitry), firmware, and/or software. Software code for performing operations in device 10 may be stored on storage circuitry 16 (e.g., storage circuitry 16 may include non-transitory (tangible) computer readable storage media that stores the software code). The software code may sometimes be referred to as program instructions, software, data, instructions, or code. Software code stored on storage circuitry 16 may be executed by processing circuitry 18.

Control circuitry 14 may be used to run software on device 10 such as satellite navigation applications, internet browsing applications, voice-over-internet-protocol (VOIP) telephone call applications, email applications, media playback applications, operating system functions, etc. To support interactions with external equipment, control circuitry 14 may be used in implementing communications protocols. Communications protocols that may be implemented using control circuitry 14 include internet protocols, wireless local area network (WLAN) protocols (e.g., IEEE 802.11 protocols - sometimes referred to as Wi-Fi^{®}), protocols for other short-range wireless communications links such as the Bluetooth^{®} protocol or other wireless personal area network (WPAN) protocols, IEEE 802.11ad protocols (e.g., ultra-wideband protocols), cellular telephone protocols (e.g., 3G protocols, 4G (LTE) protocols, 5G protocols, etc.), antenna diversity protocols, satellite navigation system protocols (e.g., global positioning system (GPS) protocols, global navigation satellite system (GLONASS) protocols, etc.), antenna-based spatial ranging protocols (e.g., radio detection and ranging (RADAR) protocols or other desired range detection protocols for signals conveyed at millimeter and centimeter wave frequencies), or any other desired communications protocols. Each communications protocol may be associated with a corresponding radio access technology (RAT) that specifies the physical connection methodology used in implementing the protocol.

Device 10 may include input-output circuitry 20. Input-output circuitry 20 may include input-output devices 22. Input-output devices 22 may be used to allow data to be supplied to device 10 and to allow data to be provided from device 10 to external devices. Input-output devices 22 may include user interface devices, data port devices, and other input-output components. For example, input-output devices 22 may include touch sensors, displays (e.g., touch-sensitive and/or force-sensitive displays), light-emitting components such as displays without touch sensor capabilities, buttons (mechanical, capacitive, optical, etc.), scrolling wheels, touch pads, key pads, keyboards, microphones, cameras, buttons, speakers, status indicators, audio jacks and other audio port components, digital data port devices, motion sensors (accelerometers, gyroscopes, and/or compasses that detect motion), capacitance sensors, proximity sensors, magnetic sensors, force sensors (e.g., force sensors coupled to a display to detect pressure applied to the display), etc. In some configurations, keyboards, headphones, displays, pointing devices such as trackpads, mice, and joysticks, and other input-output devices may be coupled to device 10 using wired or wireless connections (e.g., some of input-output devices 22 may be peripherals that are coupled to a main processing unit or other portion of device 10 via a wired or wireless link).

Input-output circuitry 20 may include wireless circuitry 24 to support wireless communications. Wireless circuitry 24 (sometimes referred to herein as wireless communications circuitry 24) may include one or more antennas. Wireless circuitry 24 may also include baseband processor circuitry, transceiver circuitry, amplifier circuitry, filter circuitry, switching circuitry, radio-frequency transmission lines, and/or any other circuitry for transmitting and/or receiving radio-frequency signals using the antenna(s).

Wireless circuitry 24 may transmit and/or receive radio-frequency signals within a corresponding frequency band at radio frequencies (sometimes referred to herein as a communications band or simply as a "band"). The frequency bands handled by wireless circuitry 24 may include wireless local area network (WLAN) frequency bands (e.g., Wi-Fi^{®} (IEEE 802.11) or other WLAN communications bands) such as a 2.4 GHz WLAN band (e.g., from 2400 to 2480 MHz), a 5 GHz WLAN band (e.g., from 5180 to 5825 MHz), a Wi-Fi^{®} 6E band (e.g., from 5925-7125 MHz), and/or other Wi-Fi^{®} bands (e.g., from 1875-5160 MHz), wireless personal area network (WPAN) frequency bands such as the 2.4 GHz Bluetooth^{®} band or other WPAN communications bands, cellular telephone frequency bands (e.g., bands from about 600 MHz to about 5 GHz, 3G bands, 4G LTE bands, 5G New Radio Frequency Range 1 (FR1) bands below 10 GHz, 5G New Radio Frequency Range 2 (FR2) bands between 20 and 60 GHz, etc.), cellular sidebands, 6G bands between 100-1000 GHz (e.g., sub-THz, THz, or THF bands), etc.), other centimeter or millimeter wave frequency bands between 10-300 GHz, near-field communications frequency bands (e.g., at 13.56 MHz), satellite navigation frequency bands (e.g., a GPS band from 1565 to 1610 MHz, a Global Navigation Satellite System (GLONASS) band, a BeiDou Navigation Satellite System (BDS) band, etc.), ultra-wideband (UWB) frequency bands that operate under the IEEE 802.15.4 protocol and/or other ultra-wideband communications protocols, communications bands under the family of 3GPP wireless communications standards, communications bands under the IEEE 802.XX family of standards, and/or any other desired frequency bands of interest.

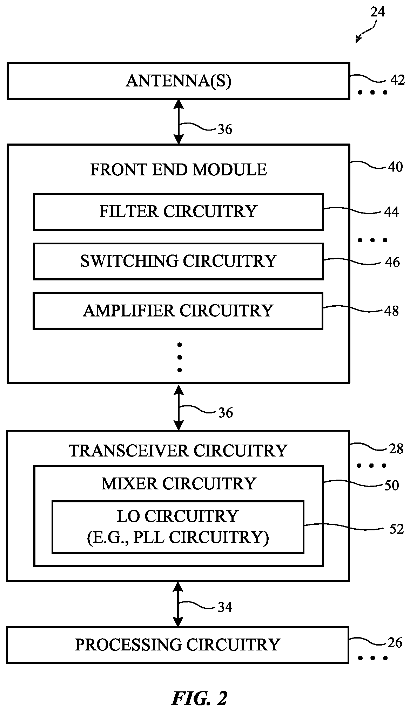

FIG. 2 is a diagram showing illustrative components within wireless circuitry 24. As shown in FIG. 2, wireless circuitry 24 may include processing circuitry such as processor circuitry 26, radio-frequency (RF) transceiver circuitry such as radio-frequency transceiver 28, radio-frequency front end circuitry such as radio-frequency front end module (FEM) 40, and antenna(s) 42. Processing circuitry 26 may be a baseband processor, an application processor, a digital signal processor, a microcontroller, a microprocessor, a central processing unit (CPU), a programmable device, a combination of these circuits, and/or one or more processors within circuitry 18. Processing circuitry 26 may be configured to generate digital (transmit or baseband) signals. Processing circuitry 26 may be coupled to transceiver 28 over path 34 (sometimes referred to as a baseband path). Transceiver 28 may be coupled to antenna 42 via radio-frequency transmission line path 36. Radio-frequency front end module 40 may be interposed on radio-frequency transmission line path 36 between transceiver 28 and antenna 42.

Wireless circuitry 24 may include one or more antennas such as antenna 42. Antenna 42 may be formed using any desired antenna structures. For example, antenna 42 may be an antenna with a resonating element that is formed from loop antenna structures, patch antenna structures, inverted-F antenna structures, slot antenna structures, planar inverted-F antenna structures, helical antenna structures, monopole antennas, dipoles, hybrids of these designs, etc. Two or more antennas 42 may be arranged into one or more phased antenna arrays (e.g., for conveying radio-frequency signals at millimeter wave frequencies). Parasitic elements may be included in antenna 42 to adjust antenna performance. Antenna 42 may be provided with a conductive cavity that backs the antenna resonating element of antenna 42 (e.g., antenna 42 may be a cavity-backed antenna such as a cavity-backed slot antenna).

In the example of FIG. 2, wireless circuitry 24 is illustrated as including only a single processing unit 26, a single transceiver 28, a single front end module 40, and a single antenna 42 for the sake of clarity. In general, wireless circuitry 24 may include any desired number of processing units 26, any desired number of transceivers 28, any desired number of front end modules 40, and any desired number of antennas 42. Each processing unit 26 may be coupled to one or more transceiver 28 over respective paths 34. Each transceiver 28 may include a transmitter circuit configured to output uplink signals to antenna 42, may include a receiver circuit configured to receive downlink signals from antenna 42, and may be coupled to one or more antennas 42 over respective radio-frequency transmission line paths 36. Each radio-frequency transmission line path 36 may have a respective front end module 40 disposed thereon. If desired, two or more front end modules 40 may be disposed on the same radio-frequency transmission line path 36. If desired, one or more of the radio-frequency transmission line paths 36 in wireless circuitry 24 may be implemented without any front end module interposed thereon.

Front end module (FEM) 40 may include radio-frequency front end circuitry that operates on the radio-frequency signals conveyed (transmitted and/or received) over radio-frequency transmission line path 36. Front end module may, for example, include front end module (FEM) components such as radio-frequency filter circuitry 44 (e.g., low pass filters, high pass filters, notch filters, band pass filters, multiplexing circuitry, duplexer circuitry, diplexer circuitry, triplexer circuitry, etc.), switching circuitry 46 (e.g., one or more radio-frequency switches), radio-frequency amplifier circuitry 48 (e.g., one or more power amplifiers and one or more low-noise amplifiers), impedance matching circuitry (e.g., circuitry that helps to match the impedance of antenna 42 to the impedance of radio-frequency transmission line 36), antenna tuning circuitry (e.g., networks of capacitors, resistors, inductors, and/or switches that adjust the frequency response of antenna 42), radio-frequency coupler circuitry, charge pump circuitry, power management circuitry, digital control and interface circuitry, and/or any other desired circuitry that operates on the radio-frequency signals transmitted and/or received by antenna 42. Each of the front end module components may be mounted to a common (shared) substrate such as a rigid printed circuit board substrate or flexible printed circuit substrate. If desired, the various front end module components may also be integrated into a single integrated circuit chip.

Filter circuitry 44, switching circuitry 46, amplifier circuitry 48, and other circuitry may be interposed within radio-frequency transmission line path 36, may be incorporated into FEM 40, and/or may be incorporated into antenna 42 (e.g., to support antenna tuning, to support operation in desired frequency bands, etc.). These components, sometimes referred to herein as antenna tuning components, may be adjusted (e.g., using control circuitry 14) to adjust the frequency response and wireless performance of antenna 42 over time.

Radio-frequency transmission line path 36 may be coupled to an antenna feed on antenna 42. The antenna feed may, for example, include a positive antenna feed terminal and a ground antenna feed terminal. Radio-frequency transmission line path 36 may have a positive transmission line signal path such that is coupled to the positive antenna feed terminal on antenna 42. Radio-frequency transmission line path 36 may have a ground transmission line signal path that is coupled to the ground antenna feed terminal on antenna 42. This example is illustrative and, in general, antennas 42 may be fed using any desired antenna feeding scheme. If desired, antenna 42 may have multiple antenna feeds that are coupled to one or more radio-frequency transmission line paths 36.

Radio-frequency transmission line path 36 may include transmission lines that are used to route radio-frequency antenna signals within device 10 (FIG. 1). Transmission lines in device 10 may include coaxial cables, microstrip transmission lines, stripline transmission lines, edge-coupled microstrip transmission lines, edge-coupled stripline transmission lines, transmission lines formed from combinations of transmission lines of these types, etc. Transmission lines in device 10 such as transmission lines in radio-frequency transmission line path 36 may be integrated into rigid and/or flexible printed circuit boards. In one suitable arrangement, radio-frequency transmission line paths such as radio-frequency transmission line path 36 may also include transmission line conductors integrated within multilayer laminated structures (e.g., layers of a conductive material such as copper and a dielectric material such as a resin that are laminated together without intervening adhesive). The multilayer laminated structures may, if desired, be folded or bent in multiple dimensions (e.g., two or three dimensions) and may maintain a bent or folded shape after bending (e.g., the multilayer laminated structures may be folded into a particular three-dimensional shape to route around other device components and may be rigid enough to hold its shape after folding without being held in place by stiffeners or other structures). All of the multiple layers of the laminated structures may be batch laminated together (e.g., in a single pressing process) without adhesive (e.g., as opposed to performing multiple pressing processes to laminate multiple layers together with adhesive).

Transceiver circuitry 28 may include wireless local area network transceiver circuitry that handles WLAN communications bands (e.g., Wi-Fi^{®} (IEEE 802.11) or other WLAN communications bands) such as a 2.4 GHz WLAN band (e.g., from 2400 to 2480 MHz), a 5 GHz WLAN band (e.g., from 5180 to 5825 MHz), a Wi-Fi^{®} 6E band (e.g., from 5925-7125 MHz), and/or other Wi-Fi^{®} bands (e.g., from 1875-5160 MHz), wireless personal area network transceiver circuitry that handles the 2.4 GHz Bluetooth^{®} band or other WPAN communications bands, cellular telephone transceiver circuitry that handles cellular telephone bands (e.g., bands from about 600 MHz to about 5 GHz, 3G bands, 4G LTE bands, 5G New Radio Frequency Range 1 (FR1) bands below 10 GHz, 5G New Radio Frequency Range 2 (FR2) bands between 20 and 60 GHz, etc.), near-field communications (NFC) transceiver circuitry that handles near-field communications bands (e.g., at 13.56 MHz), satellite navigation receiver circuitry that handles satellite navigation bands (e.g., a GPS band from 1565 to 1610 MHz, a Global Navigation Satellite System (GLONASS) band, a BeiDou Navigation Satellite System (BDS) band, etc.), ultra-wideband (UWB) transceiver circuitry that handles communications using the IEEE 802.15.4 protocol and/or other ultra-wideband communications protocols, and/or any other desired radio-frequency transceiver circuitry for covering any other desired communications bands of interest.

In performing wireless transmission, processing circuitry 26 may provide digital baseband signals to transceiver 28 over path 34. Transceiver 28 may further include circuitry for converting the baseband signals received from processing circuitry 26 into corresponding intermediate frequency or radio-frequency signals. For example, transceiver circuitry 28 may include mixer circuitry 50 for up-converting (or modulating) the baseband signals to intermediate frequencies or radio frequencies prior to transmission over antenna 42. Transceiver circuitry 28 may also include digital-to-analog converter (DAC) and/or analog-to-digital converter (ADC) circuitry for converting signals between digital and analog domains. Transceiver 28 may include a transmitter component to transmit the radio-frequency signals over antenna 42 via radio-frequency transmission line path 36 and front end module 40. Antenna 42 may transmit the radio-frequency signals to external wireless equipment by radiating the radio-frequency signals into free space.

In performing wireless reception, antenna 42 may receive radio-frequency signals from the external wireless equipment. The received radio-frequency signals may be conveyed to transceiver 28 via radio-frequency transmission line path 36 and front end module 40. Transceiver 28 may include circuitry for converting the received radio-frequency signals into corresponding intermediate frequency or baseband signals. For example, transceiver 28 may use mixer circuitry 50 for down-converting (or demodulating) the received radio-frequency signals to baseband frequencies prior to conveying the received signals to processing circuity 26 over path 34. Mixer circuitry 50 can include local oscillator (LO) circuitry such as a local oscillator circuitry 52. Local oscillator circuitry 52 can generate oscillator signals that mixer circuitry 50 uses to modulate transmitting signals from baseband frequencies to radio frequencies and/or to demodulate the received signals from radio frequencies to baseband frequencies. Device configurations in which LO circuitry 52 is implemented using phase-locked loops (see, e.g., PLL circuitry 52) are sometimes described as an example herein.

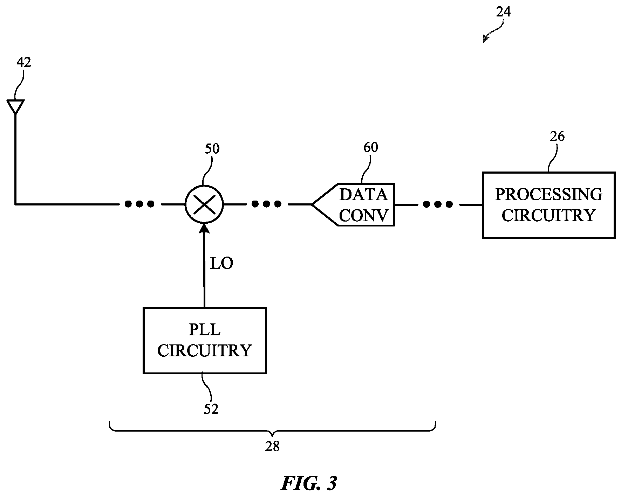

FIG. 3 is a diagram of wireless circuitry 24 showing transceiver 28 coupled between antenna 42 and processing circuitry 26. In general, one or more circuit components (e.g., circuits within front-end module 40 shown in FIG. 2 or other radio-frequency components) may be interposed between antenna 42 and transceiver 28. Similarly, one or more circuit components may be interposed between transceiver 28 and processing circuitry 26. Transceiver 28 may include one or more mixers such as mixer 50. Mixer 50 may be configured to modulate (or demodulate) between a radio frequency and a baseband frequency or an intermediate frequency that is less than the radio frequency. Transceiver 28 may also include a data conversion circuit such as an analog-to-digital converter (ADC) and/or a digital-to-analog converter (DAC) configured to convert signals between an analog domain and a digital domain (e.g., signals interfacing with the mixers and/or antenna 42 are in the analog domain, whereas signals interfacing with processing circuitry 26 are in the digital domain). Mixer 50 may be configured to receive a local oscillator signal LO from a local oscillator signal generator such as phase-locked loop (PLL) circuitry 52.

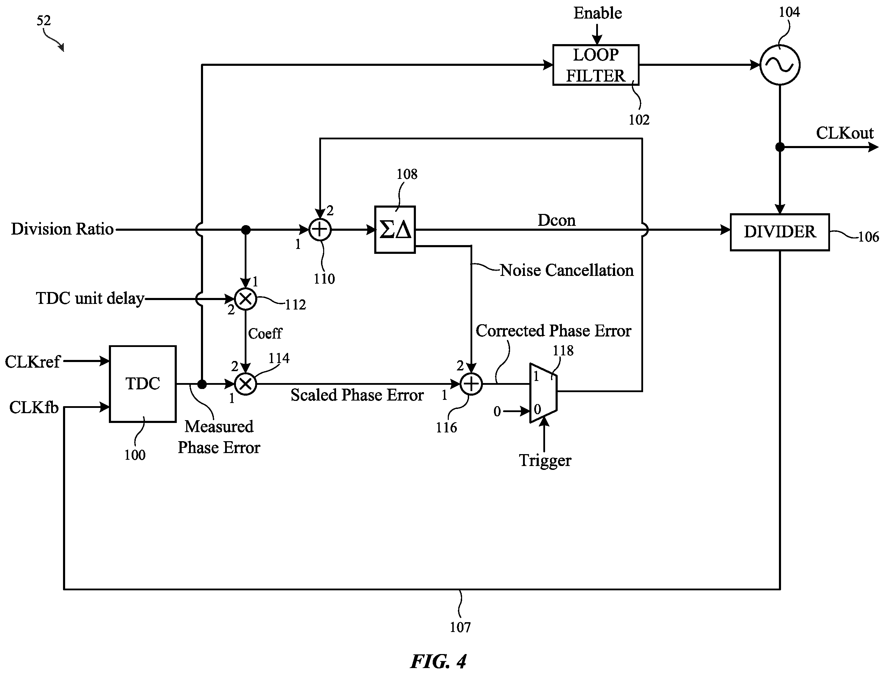

FIG. 4 is a diagram of illustrative PLL circuitry 52 in accordance with an embodiment. As shown in FIG. 4, PLL circuitry 52 may include a time-to-digital converting circuit such as time-to-digital converter (TDC) 100, a filter circuit such as a digital loop filter 102, an oscillator circuit such a digitally controlled oscillator (DCO) 104, and a frequency division circuit such as frequency divider 106. Time-to-digital converter 100 may have a first input configured to receive a reference clock signal CLKref (e.g., a clock signal having frequency *f*_*ref*), a second input configured to receive a feedback clock signal CLKfb (e.g., a clock signal having frequency *f*_*fb*), and an output on which a digital signal that is proportional to the phase/time difference between signals CLKref and CLKfb can be generated. Time-to-digital converter 100 may, for example, generate at its output a digital signal that is proportional to the time interval between rising edges of the reference and feedback clock signals or between the falling edges of the reference and feedback clock signals. This digital output signal that is produced by time-to-digital converter 100 can be referred to as a measured phase error or phase offset.

The digital loop filter 102 may be coupled to the output of time-to-digital converter 100 and can be configured to output a corresponding filtered digital signal (e.g., a filtered binary code). Digital loop filter 102 can be selectively enabled or disabled by an associated loop filter enable signal. When the enable signal is asserted (e.g., driven to a logic "1"), loop filter 102 can be switched into use or activated to close the loop of the PLL circuitry 52. When the enable signal is deasserted (e.g., driven to a logic "0"), loop filter 102 can be switched out of use or deactivated to open the loop of the PLL circuitry 52.

Digitally controlled oscillator 104, sometimes referred to more generically as a variable oscillator, may have an input coupled to digital loop filter 102 and an output at which an output clock signal CLKout with clock frequency *f*_*out* is generated. The clock frequency *f*_*out* of oscillator clock signal CLKout can be a function of the filtered digital signal received from digital loop filter 102. Various ways of implementing a digitally controlled oscillator 104 can be employed.

Frequency divider 106 may have an input coupled to the output of digitally controlled oscillator 104 and an output coupled to the second input of time-to-digital converter 100, as shown by feedback path 107. Connected in a loop in this way, phase-locked loop circuitry 52 can generate output clock signal CLKout with frequency *f*_*out* while ensuring that the phase difference (phase error) between clock signals CLKref and CLKfb at the inputs of TDC 100 are minimized, fixed to some non-zero phase value, or otherwise controlled. In general, the PLL output frequency *f*_*out* is equal to *f*_*ref**N, where N is the frequency division factor of divider 106. For example, frequency division factor N of divider 106 can an integer that is greater than 10, greater than 20, greater than 40, greater than 60, greater than 80, 20-100, 80-120, 60-140, or at least 100. Reference clock frequency *f*_*ref* may be in the Megahertz or Gigahertz frequency range (e.g., *f*_*ref* may be 1-10 MHz, 10-100 MHz, at least 100 MHz, 100 MHz to 1 GHz, less than 1 GHz, 0.1 GHz, 0.5 GHz, 0.1-1 GHz, etc.). Thus, in an example where reference clock frequency *f*_*ref* is equal to 80 MHz and the divisional factor N is equal to 100, the output clock frequency *f*_*out* will be equal to 8 GHz (i.e., 80 MHz multiplied by 100). A phase-locked loop implemented using time-to-digital converter (TDC) 100, digital loop filter 102, digitally controlled oscillator 104 is sometimes referred to as a "digital" phase-locked loop.

Frequency divider 106 may be a multi-modulus divider (MMD). Multi-modulus frequency divider 106 can refer to a digital frequency divider configured to divide an input frequency such as frequency *f*_*out* by one or more programmable integers. Unlike a fixed frequency divider, multi-modulus divider 106 can dynamically switch between a range of division ratios based on a digital control signal Dcon. In the example of FIG. 4,multi-modulus (frequency) divider 106 can receive digital control signal Dcon from a digital modulator such as a sigma delta (ΣΔ) modulator 108. Sigma delta modulator 108 can also sometimes referred to alternatively as a delta sigma (ΔΣ) modulator. Sigma delta modulator 108 can output a time-varying bitstream (e.g., a bit stream with some pattern of logic ones and zero) for adjusting the division ratio of multi-modulus divider 106 in real time.

In some embodiments, digital PLL circuitry 52 can be a "fractional" phase-locked loop. As an example, a fractional PLL might be able to generate output clock signals having frequencies equal to 12.5**f*_*ref*, 12.4**f*_*ref*, 12.3**f*_*ref*, 12.2**f*_*ref*, 12.1**f*_*ref*, 12.01**f*_*ref*, 12.001**f*_*ref*, 12.0001**f*_*ref*, and so on. Such type of phase-locked loop in which the PLL is not limited to any step size (raster) and can theoretically support an infinite number of channels is defined as a "full-fractional" PLL. As another example, a fractional PLL might be configured to generate clock signals having frequencies equal to 12**f*_*ref*, 12.25**f*_*ref*, 12.50**f*_*ref*, and 12.75**f*_*ref.* In this example, the step size (PLL raster) is equal to 0.25**f*_*ref*, and the number of channels is equal to four. Such type of phase-locked loop where the step size or raster is some predetermined fraction of *f*_*ref* is defined as a "partial-fractional" PLL. This example in which the partial-fractional PLL has four channels is illustrative. Partial-fractional PLLs can have 2 channels, 4 channels, 8 channels, 16 channels, 32 channels, or in general 2^N number of channels where N is an integer equal to or greater than one. Partial-fractional PLLs can offer a finer frequency control relative to integer PLLs.

It is generally desirable to have a precise feedback clock signal CLKfb to start with a small phase error relative to the reference clock signal CLKref. A larger starting phase error between signals CLKref and CLKfb results in a longer convergence time for the digital PLL circuitry 52 (e.g., taking longer for the phase error to settle within some locking criteria). In practice, the initial phase of signal CLKfb can be subject to various uncertainties before the loop is closed. For instance, digital PLL circuitry 52 typically starts the digitally controlled oscillator 104 in some arbitrary clock phase relative to reference clock signal CLKref and, in the case of a fractional PLL, the phase of CLKfb can continuously change in time between oscillator 104 being enabled and the loop closing. There is no expected DCO phase when the loop is being closed. Moreover, there can be uncertainty with frequency divider 106 being activated due to synchronization issues between different clock domains associated with clock signals CLKref and CLKout, due to divider 106 and sigma delta modulator 108 running in different clock domains. Due to these uncertainties, the phase of feedback clock signal CLKfb output from divider 106 can be unpredictable but is expected to start in a certain range within a couple of DCO clock cycles.

In accordance with an embodiment, digital PLL circuitry 52 can be further provided with digital phase alignment circuit components configured to ensure that the feedback clock signal CLKfb is driven within a well-defined range around the expected TDC timing for faster phase locking. Still referring to FIG. 4, PLL circuitry 52 can further include a multiplication circuits such as multipliers 112 and 114, signal combining circuits such as signal combiners 110 and 116, and a multiplexing circuit (component) such as multiplexer 118. These components 110, 112, 114, 116, and 118 can collectively be considered to be part of the digital phase alignment (DPA) circuit.

Multiplier 112 can have a first input configured to receive a division ratio, a second input configured to receive a time-to-digital converter (TDC) unit delay, and an output on which a corresponding phase alignment coefficient is produced. The division ratio can have a fractional (non-integer) value that is a function of division factor N. The TDC unit delay may be a number representing an average resolution or granularity of TDC 100, expressed in units of time. The TDC unit delay might not exactly match the actual physical value of the TDC resolution, which can vary as a function of temperature and/or analog mismatch. The phase alignment coefficient, sometimes referred to as a phase correction coefficient, can be equal to a product of the division ratio and the TDC unit delay values. The phase alignment coefficient can thus have a frequency dependent value. The phase alignment coefficient is generally a static value, which can optionally be computed in advance and saved into a non-volatile memory component.

Multiplier 114 can have a first input configured to receive the measured phase error from time-to-digital converter 100, a second input configured to receive the phase alignment coefficient from multiplier 112, and an output at which a corresponding scaled phase error is produced. The scaled phase error output from multiplier 114 can represent an uncorrected phase error in units of the DCO clock cycle. The scaled phase error, sometimes referred to as uncorrected phase error, can be equal to a product of the measured phase error and the phase correction coefficient. Operated in this way, multiplier 114 can serve as a signal scaling component for converting the measured phase error (in TDC unit delays) to the DCO clock domain. Multiplier 114 is thus sometimes referred to as a phase error scaler.

Combiner 116 can have a first input configured to receive the scaled phase error from multiplier 114, a second input configured to receive a noise cancellation signal (sometimes referred to as noise cancelling information) from sigma delta modulator 108, and an output at which a corresponding corrected phase error can be produced. Combiner 116 can compute the corrected phase error by calculating a sum of the scaled phase error and the noise cancellation signal or by subtracting the noise cancellation signal from the scaled phase error. Combiner 116 is thus sometimes referred to as a summing circuit or a subtraction circuit. The corrected phase error is sometimes referred to as an estimated phase error. Thus, the estimated phase error can be generated based on the scaled phase error and the noise cancellation information output from sigma delta modulator 108.

The corrected phase error can be conveyed to multiplexer 118. Multiplexer 118 can have a first input configured to receive the corrected phase error from combiner 116, a second input configured to receive a null signal (e.g., a signal with a correction value of zero), a control input configured to receive a trigger signal, and an output. The trigger signal can represent a digital timing control signal for selectively activating the digital phase alignment circuit. The trigger signal can be generated by a controller within transceiver 28 (see FIG. 2), a controller within processing circuitry 26, or a controller within control circuitry 14 (see FIG. 1). The controller can be implemented as a finite state machine (e.g., a finite state machine that can be considered part of the digital phase alignment circuit). When the trigger signal has a first value (e.g., logic "0"), multiplexer 118 can be configured to pass the zero value to its output. When the trigger signal is set to a second value (e.g., a signal with a correction value of one) different than the first value, multiplexer 118 can be configured to pass the corrected phase error to its output. Multiplexer 118 operated in this way is sometimes referred to more generically as a switching component.

Combiner 110 may have a first input configured to receive the division ratio, a second input coupled to the output of multiplexer 118, and an output that is coupled to sigma delta modulator 108. Combiner 110 can be configured to add the division ratio and the signal received from multiplexer 118 and is therefore sometimes referred to as a summing circuit. Thus, when the trigger signal associated with multiplexer 118 is low, multiplexer 118 outputs a null signal to the second input of combiner 110, so combiner 110 can simply output the division ratio to sigma delta modulator 108. However, when the trigger signal is high, multiplexer 118 will output the corrected phase error to the second input of combiner 110, so combiner 110 will output a compensated division ratio that has been adjusted based on the corrected phase error. The output of combiner 110, during such times, can sometimes be referred to as a phase error corrected division ratio. Sigma delta modulator 108 can adjust Dcon that is provided to frequency divider 106, based on the phase error corrected division ratio. In other words, frequency divider 106 can be adjusted based on the corrected phase error output by the digital phase alignment circuit.

The particular arrangement of the digital phase alignment circuit shown in FIG. 4 is illustrative. If desired, the order of the signal estimation, scaling, and correction components can optionally be rearranged or reordered without departing from the scope of the present embodiments. For example, the phase error correction can be applied at the input of sigma delta modulator 108 (as shown in the embodiment of FIG. 4) or can alternatively be applied at the output of sigma delta modulator 108. Applying the phase correction at the input side of sigma delta modulator 108 allows any phase adjustment to be fractions of the DCO clock cycle. This might be advantageous for fractional PLLs. Conversely, applying the phase correction at the output side of sigma delta modulator 108 can restrict the correction to integer-only phase adjustments, which might be suitable for integer PLLs.

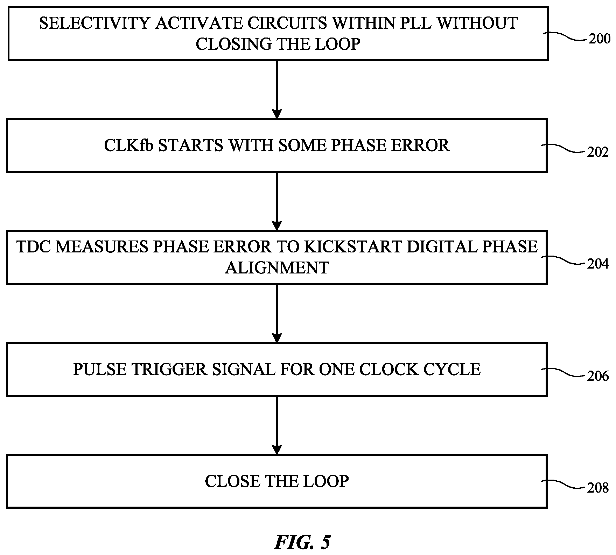

FIG. 5 is a flowchart of illustrative steps for operating digital PLL circuitry 52 of the type described in connection with FIG. 4. During the operations of block 200, one or more components within PLL circuitry 52 can be selectively activated without closing the phase-locked loop (e.g., the PLL circuitry 52 should remain in an open-loop state). For example, the TDC 100, sigma delta modulator 108, frequency divider 106, and/or digitally controlled oscillator 104 can be activated. In particular, the digitally controlled oscillator 104 can be activated before frequency divider 106. As an example, loop filter 102 should remain deactivated until a later time. As another example, some other component in the phase-locked loop can remain deactivated until a later time (e.g., loop filter 102 can optionally be enabled at block 200 while another block in the loop is disabled to ensure the open-loop state).

During the operations of block 202, the feedback clock signal CLKfb can start toggling with some initial phase error. For example, multi-modulus frequency divider 106 may begin outputting clock signal CLKfb having some phase error.

During the operations of block 204, TDC 100 may be configured to measure a phase error between incoming clock signals CLKref and CLKfb. For example, TDC 100 can output a measured phase error that would kickstart the digital phase alignment (DPA) process. For instance, once the measured phase error is available, multiplier 114 can compute a corresponding scaled phase error based on a phase alignment coefficient received from multiplier 112. Subsequently, combiner 116 can then compute a corrected phase error based on the scaled phase error and noise cancellation information received from sigma delta modulator 108.

During the operations of block 206, the trigger signal can be pulsed high temporarily. For example, the trigger signal can be pulsed high for only one clock cycle. Prior to block 206, the trigger signal is deasserted (e.g., held at a low level), which effectively deactivates multiplexer 118 by nulling out any signal that is fed to the second input of combiner 110. When the trigger signal is asserted (e.g., driven to a high level), however, multiplexer 118 will pass the corrected phase error to the second input of combiner 110. Thereafter, the phase-locked loop can finally be closed (see operations of block 208). In the example where loop filter 102 is disabled at block 200, loop filter 102 can finally be enabled at block 208. If desired, some other component in the loop can be selectively disabled and enabled in this way to close the loop at block 208 (e.g., to configured PLL circuitry 52 in a "close-loop" state). The component being selectively activated and deactivated to control the closing of the loop can receive an enable signal. In other words, the digital phase alignment operations should be applied while the digital PLL circuitry 52 is in the "open-loop" state. This example in which the trigger signal is pulsed high for only one clock cycle is illustrative. If desired, a multi-cycle correction can be employed, which can enable averaging measurement values and/or compensation of measurement patterns (e.g., duty cycle distortion correction). In such cases, the phase error correction can be applied over multiple clock cycles, and the corrected phase error value can be scaled (divided) by the total correction length.

The operations of FIG. 5 are illustrative. If desired, the digital phase alignment operations of FIG. 5 can be applied multiple times to minimize any remaining phase error. In such cases, the loop should not be closed until the corrected feedback clock measurement is again available via the TDC sampling. In some embodiments, one or more of the described operations may be modified, replaced, or omitted. In some embodiments, one or more of the described operations may be performed in parallel. In some embodiments, additional processes may be added or inserted between the described operations. If desired, the order of certain operations may be reversed or altered and/or the timing of the described operations may be adjusted so that they occur at slightly different times. In some embodiments, the described operations may be distributed in a larger system.

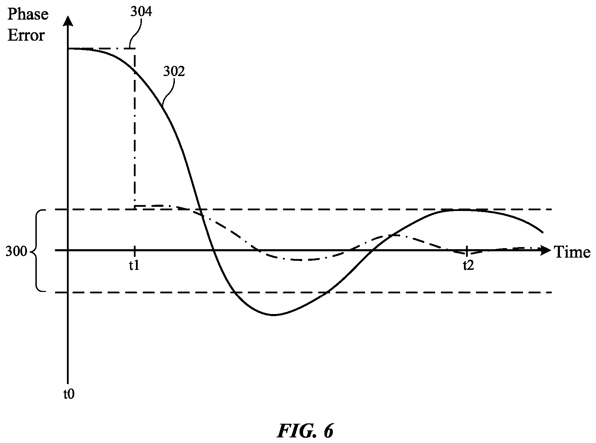

FIG. 6 is a timing diagram showing how PLL circuitry 52 operated based on the operations of the type described in connection with FIG. 5 can reduce phase error in accordance with some embodiments. Waveform 302 represents the phase error associated with the digital PLL circuitry without any digital phase alignment. For such PLL without any digital phase alignment correction, it is assumed that the PLL loop is closed at time t0 (i.e., loop filter 102 is enabled from the very start), so the phase error will being converging immediately. As shown in FIG. 6, waveform 302 can swing over a wide range of phase error levels and can eventually settle (converge) within a target locking condition margin 300 after time t2. The target locking condition margin 300 can represent a minimum tolerable phase error in accordance with a given phase error specification. In general, a larger initial phase error at t0 will generally result in longer locking times, where the locking time t2 will be pushed out even further.

In contrast, waveform 304 represents the phase error associated with digital PLL circuitry 52 that employs the digital phase alignment process/components described above in connection with at least FIGS. 4 and 5. Here, the digital phase alignment process begins immediately at time t0 but PLL loop remains open at time t0 (e.g., loop filter 102 is initially disabled). The phase error measurement can be obtained at time t0. At this instant, the trigger signal associated with multiplexer 118 can be asserted (e.g., for one or more clock cycles). After the trigger signal is asserted, the measurement is scaled and the correction is transferred to sigma delta modulator 108 in the same clock cycle. This correction can then propagate through sigma delta modulator 108, divider 106, and TDC 100. A small time interval later, TDC 100 can start to provide the corrected measurements at time t1, which causes the phase error to drop sharply due to the new TDC measurements and the corrected noise cancellation. The loop can then be closed (e.g., by enabling the loop filter or other component). Thereafter, the phase error can quickly settle within the target locking condition margin 300 way before time t2. The time interval from time t0 to t1 can take some (e.g., a few clock cycles) while the delivered values are not used for loop closing.

The example of FIG. 6 in which the loop is open at time t0 is illustrative. In other embodiments, the loop can optionally be closed at time t0. When fast loop closing is important, the values measured by TDC 100 and the noise cancellation information can be corrected temporarily (e.g., from time t0 to t1) according to the applied correction to sigma delta modulator 108, which allows the loop to be closed at time t0. Then at time t1, the temporary correction can be removed.

The example of FIG. 6 in which waveform 304 falls, at time t1, to a level just outside the target locking condition margin 300 and then quickly settles within margin 300 is illustrative. If the initial phase error at time t0 were lower, then waveform 304 can fall at time t1 to a level within the target locking condition margin 300, resulting in an instant phase lock. Phase-locked loop circuitry 52 that includes digital phase alignment circuit components configured and operated in this way can be technically advantageous and beneficial by enable significantly faster locking times due the dramatically reduced feedback clock phase error at the time of loop closing, which can also provide power savings by allowing slower reference clock frequencies while meeting lock and re-lock timing requirements. Shorter lock times can also allow optimization of more PLL off times.

The methods and operations described above in connection with FIGS. 1-6 may be performed by the components of device 10 using software, firmware, and/or hardware (e.g., dedicated circuitry or hardware). Software code for performing these operations may be stored on non-transitory computer readable storage media (e.g., tangible computer readable storage media) stored on one or more of the components of device 10 (e.g., storage circuitry 16 and/or wireless communications circuitry 24 of FIG. 1). The software code may sometimes be referred to as software, data, instructions, program instructions, or code. The non-transitory computer readable storage media may include drives, non-volatile memory such as non-volatile random-access memory (NVRAM), removable flash drives or other removable media, other types of random-access memory, etc. Software stored on the non-transitory computer readable storage media may be executed by processing circuitry on one or more of the components of device 10 (e.g., processing circuitry in wireless circuitry 24, processing circuitry 18 or control circuitry 14 of FIG. 1, etc.). The processing circuitry may include microprocessors, application processors, digital signal processors, central processing units (CPUs), application-specific integrated circuits with processing circuitry, or other processing circuitry.

In accordance with an embodiment, phase-locked loop circuitry includes: a time-to-digital converter having a first input configured to receive a reference clock signal, a second input configured to receive a feedback clock signal, and an output at which a measured phase error is produced; a frequency divider configured to output the feedback clock signal; and a phase alignment circuit configured to output a corrected phase error that is used in adjusting the frequency divider.

In accordance with another embodiment, the phase-locked loop circuitry optionally further includes a digitally controlled oscillator configured to produce an output clock signal that is conveyed to the frequency divider and a digital loop filter having an output coupled to the digitally controlled oscillator.

In accordance with another embodiment, the digital loop filter optionally has an input coupled to the time-to-digital converter.

In accordance with another embodiment, the phase-locked loop circuitry optionally further includes a sigma delta modulator configured to output a control signal to the frequency divider.

In accordance with another embodiment, the phase alignment circuit optionally includes a scaling component configured to scale the measured phase error by a phase alignment coefficient to produce a corresponding scaled phase error.

In accordance with another embodiment, the phase alignment coefficient is optionally equal to a product of a division ratio associated with the frequency divider and a parameter associated with the time-to-digital converter.

In accordance with another embodiment, the phase alignment circuit optionally further includes a multiplexing component configured to selectively output a corrected phase error that is used in controlling the sigma delta modulator.

In accordance with another embodiment, the corrected phase error is optionally generated based on the scaled phase error and a noise cancellation signal output from the sigma delta modulator.

In accordance with another embodiment, the sigma delta modulator is optionally controlled by a signal computed based on a division ratio associated with the frequency divider and the corrected phase error output from the multiplexing component.

In accordance with another embodiment, the multiplexing component is optionally further configured to receive a null signal and a trigger signal, output the null signal when trigger signal has a first value, and output the corrected phase error when the trigger has a second value different than the first value.

In accordance with another embodiment, the trigger signal is optionally pulsed high for one or more clock cycles.

In accordance with another embodiment, the trigger signal is optionally temporarily pulsed high, and at least one component in the phase-locked loop circuitry is optionally disabled before the trigger signal is pulsed high to configure the phase-locked loop circuitry in an open-loop state and is optionally enabled after the trigger signal is pulsed high to configure the phase-locked loop circuitry in a close-loop state.

In accordance with another embodiment, the phase alignment circuit optionally further includes a finite state machine configured to output the trigger signal.

In accordance with another embodiment, the frequency divider optionally includes a multi-modulus divider.

In accordance with an embodiment, a method of operating phase-locked loop circuitry includes: selectively activating one or more components within the phase-locked loop circuitry while the phase-locked loop circuitry remains in an open-loop state, where the one or more components being activated include a time-to-digital converter and a frequency divider; with the frequency divider, outputting a feedback clock signal; with the time-to-digital converter, receiving a reference clock signal and the feedback clock signal and outputting a corresponding measured phase error; and with a phase alignment circuit, outputting a corrected phase error based on the measured phase error and adjusting the frequency divider based on the corrected phase error.

In accordance with another embodiment, the method optionally further includes: with a sigma delta modulator, outputting a control signal to the frequency divider, where the control signal is generated based on the corrected phase error and a division ratio associated with the frequency divider.

In accordance with another embodiment, the method optionally further includes: with a multiplexing component, receiving the corrected phase error, a null signal, and a trigger signal; and with the multiplexing component, outputting the null signal when the trigger signal has a first value and outputting the corrected phase error when the trigger signal has a second value different than the first value.

In accordance with another embodiment, the method optionally further includes computing a scaled phase error based on the measured phase error and a static phase alignment coefficient and computing the corrected phase error by combining the scaled phase error and noise cancellation information output from the sigma delta modulator.

In accordance with an embodiment, circuitry includes a plurality of circuit components selectively coupled together in a loop and having a phase error and a digital phase alignment circuit coupled to the plurality of circuit components and configured to reduce the phase error from a first value to a second value before a component in the plurality of circuit components is enabled to close the loop.

In accordance with another embodiment, the plurality of circuit components optionally includes a time-to-digital converter, a loop filter, a frequency divider, and an oscillator, and the digital phase alignment circuit is optionally configured to apply a correction value to a signal received at an input of a sigma delta modulator coupled to the frequency divider.

The foregoing is illustrative and various modifications can be made to the described embodiments. The foregoing embodiments may be implemented individually or in any combination.

It is well understood that the use of personally identifiable information should follow privacy policies and practices that are generally recognized as meeting or exceeding industry or governmental requirements for maintaining the privacy of users. In particular, personally identifiable information data should be managed and handled so as to minimize risks of unintentional or unauthorized access or use, and the nature of authorized use should be clearly indicated to users.

Exemplary embodiments of the present disclosure are set out in the following items:
1. Phase-locked loop circuitry comprising:
   a time-to-digital converter having a first input configured to receive a reference clock signal, a second input configured to receive a feedback clock signal, and an output at which a measured phase error is produced;
   a frequency divider configured to output the feedback clock signal; and
   a phase alignment circuit configured to output a corrected phase error that is used in adjusting the frequency divider.
2. The phase-locked loop circuitry of item 1, further comprising:
   a digitally controlled oscillator configured to produce an output clock signal that is conveyed to the frequency divider; and
   a digital loop filter having an output coupled to the digitally controlled oscillator.
3. The phase-locked loop circuitry of item 2, wherein the digital loop filter has an input coupled to the time-to-digital converter.
4. The phase-locked loop circuitry of any of items 2-3, further comprising:
   a sigma delta modulator configured to output a control signal to the frequency divider.
5. The phase-locked loop circuitry of any of items 1-4, wherein the phase alignment circuit comprises:
   a scaling component configured to scale the measured phase error by a phase alignment coefficient to produce a corresponding scaled phase error.
6. The phase-locked loop circuitry of item 5, wherein the phase alignment coefficient is equal to a product of a division ratio associated with the frequency divider and a parameter associated with the time-to-digital converter.
7. The phase-locked loop circuitry of any of items 5-6, wherein the phase alignment circuit further comprises:
   a multiplexing component configured to selectively output a corrected phase error that is used in controlling the sigma delta modulator.
8. The phase-locked loop circuitry of item 7, wherein the corrected phase error is generated based on the scaled phase error and a noise cancellation signal output from the sigma delta modulator.
9. The phase-locked loop circuitry of any of items 7-8, wherein the sigma delta modulator is controlled by a signal computed based on a division ratio associated with the frequency divider and the corrected phase error output from the multiplexing component.
10. The phase-locked loop circuitry of any of items 7-9, wherein the multiplexing component is further configured to:
   receive a null signal and a trigger signal;
   output the null signal when trigger signal has a first value; and
   output the corrected phase error when the trigger has a second value different than the first value.
11. The phase-locked loop circuitry of item 10, wherein the trigger signal is pulsed high for one or more clock cycles.
12. The phase-locked loop circuitry of any of items 10-11, wherein the trigger signal is temporarily pulsed high, and wherein at least one component in the phase-locked loop circuitry is disabled before the trigger signal is pulsed high to configure the phase-locked loop circuitry in an open-loop state and is enabled after the trigger signal is pulsed high to configure the phase-locked loop circuitry in a close-loop state.
13. The phase-locked loop circuitry of any of items 10-12, wherein the phase alignment circuit further comprises a finite state machine configured to output the trigger signal.
14. The phase-locked loop circuitry of any of items 1-13, wherein the frequency divider comprises a multi-modulus divider.
15. A method of operating phase-locked loop circuitry, comprising:
   selectively activating one or more components within the phase-locked loop circuitry while the phase-locked loop circuitry remains in an open-loop state, wherein the one or more components being activated comprise a time-to-digital converter and a frequency divider;
   with the frequency divider, outputting a feedback clock signal;
   with the time-to-digital converter, receiving a reference clock signal and the feedback clock signal and outputting a corresponding measured phase error; and
   with a phase alignment circuit, outputting a corrected phase error based on the measured phase error and adjusting the frequency divider based on the corrected phase error.
16. The method of item 15, further comprising:
   with a sigma delta modulator, outputting a control signal to the frequency divider, wherein the control signal is generated based on the corrected phase error and a division ratio associated with the frequency divider.
17. The method of item 16, further comprising:
   with a multiplexing component, receiving the corrected phase error, a null signal, and a trigger signal; and
   with the multiplexing component, outputting the null signal when the trigger signal has a first value and outputting the corrected phase error when the trigger signal has a second value different than the first value.
18. The method of any of items 16-17, further comprising:
   computing a scaled phase error based on the measured phase error and a static phase alignment coefficient; and
   computing the corrected phase error by combining the scaled phase error and noise cancellation information output from the sigma delta modulator.
19. Circuitry comprising:
   a plurality of circuit components selectively coupled together in a loop and having a phase error; and
   a digital phase alignment circuit coupled to the plurality of circuit components and configured to reduce the phase error from a first value to a second value before a component in the plurality of circuit components is enabled to close the loop.
20. The circuitry of item 19, wherein:
   the plurality of circuit components comprise a time-to-digital converter, a loop filter, a frequency divider, and an oscillator; and
   the digital phase alignment circuit is configured to apply a correction value to a signal received at an input of a sigma delta modulator coupled to the frequency divider.

## Claims

1. Phase-locked loop circuitry comprising:
a time-to-digital converter having a first input configured to receive a reference clock signal, a second input configured to receive a feedback clock signal, and an output at which a measured phase error is produced;
a frequency divider configured to output the feedback clock signal; and
a phase alignment circuit configured to output a corrected phase error that is used in adjusting the frequency divider.

2. The phase-locked loop circuitry of claim 1, further comprising:
a digitally controlled oscillator configured to produce an output clock signal that is conveyed to the frequency divider; and
a digital loop filter having an output coupled to the digitally controlled oscillator.

3. The phase-locked loop circuitry of claim 2, wherein the digital loop filter has an input coupled to the time-to-digital converter.

4. The phase-locked loop circuitry of any of claims 2-3, further comprising:
a sigma delta modulator configured to output a control signal to the frequency divider.

5. The phase-locked loop circuitry of any of claims 1-4, wherein the phase alignment circuit comprises:
a scaling component configured to scale the measured phase error by a phase alignment coefficient to produce a corresponding scaled phase error.

6. The phase-locked loop circuitry of claim 5, wherein the phase alignment coefficient is equal to a product of a division ratio associated with the frequency divider and a parameter associated with the time-to-digital converter.

7. The phase-locked loop circuitry of any of claims 5-6, wherein the phase alignment circuit further comprises:
a multiplexing component configured to selectively output a corrected phase error that is used in controlling the sigma delta modulator.

8. The phase-locked loop circuitry of claim 7, wherein the corrected phase error is generated based on the scaled phase error and a noise cancellation signal output from the sigma delta modulator.

9. The phase-locked loop circuitry of any of claims 7-8, wherein the sigma delta modulator is controlled by a signal computed based on a division ratio associated with the frequency divider and the corrected phase error output from the multiplexing component.

10. The phase-locked loop circuitry of any of claims 7-9, wherein the multiplexing component is further configured to:
receive a null signal and a trigger signal;
output the null signal when trigger signal has a first value; and
output the corrected phase error when the trigger has a second value different than the first value.

11. The phase-locked loop circuitry of any of claims 1-10, wherein the frequency divider comprises a multi-modulus divider.

12. A method of operating phase-locked loop circuitry, comprising:
selectively activating one or more components within the phase-locked loop circuitry while the phase-locked loop circuitry remains in an open-loop state, wherein the one or more components being activated comprise a time-to-digital converter and a frequency divider;
with the frequency divider, outputting a feedback clock signal;
with the time-to-digital converter, receiving a reference clock signal and the feedback clock signal and outputting a corresponding measured phase error; and
with a phase alignment circuit, outputting a corrected phase error based on the measured phase error and adjusting the frequency divider based on the corrected phase error.

13. The method of claim 12, further comprising:
with a sigma delta modulator, outputting a control signal to the frequency divider, wherein the control signal is generated based on the corrected phase error and a division ratio associated with the frequency divider.

14. The method of claim 13, further comprising:
with a multiplexing component, receiving the corrected phase error, a null signal, and a trigger signal; and
with the multiplexing component, outputting the null signal when the trigger signal has a first value and outputting the corrected phase error when the trigger signal has a second value different than the first value.

15. The method of any of claims 13-14, further comprising:
computing a scaled phase error based on the measured phase error and a static phase alignment coefficient; and
computing the corrected phase error by combining the scaled phase error and noise cancellation information output from the sigma delta modulator.
